# EUROPEAN PATENT SPECIFICATION

(11) **EP 2 289 983 B1**
(45) Date of publication and mention of the grant of the patent: **18.01.2012**
(21) Application number: 10174842.4
(22) Date of filing: 01.09.2010
(51) Int. Cl.: C08J 5/18, C08J 7/04, H01L 31/0216

(54) **Composite film**
Verbundfolie
Film composite

(30) Priority: 01.09.2009 JP 2009201314
(43) Date of publication of application: 02.03.2011
(73) Proprietor: FUJIFILM Corporation, Tokyo 106-0031 (JP)
(72) Inventor: Oouchi, Ryou, Kanagawa 258-8577 (JP)
(74) Representative: HOFFMANN EITLE

(56) References cited:
- EP-A1- 2 033 986
- EP-A2- 2 050 780
- WO-A1-2010/069958
- WO-A2-2007/042993

## Description

### THE RELATED ART OF THE INVENTION

Heretofore, laminating of films has been investigated for the purpose of enhancing property shutting transmittance of water vapor or oxygen, that is, gas barrier property (JP-A-2004-285183, JP-A-2001-213927, and JP-A-2002-275448).

Concerning gas barrier films comprising a barrier layer having an organic layer and an inorganic layer (hereinafter, sometimes referred to as "organic-inorganic laminate type gas barrier film"), it is also predictable that the barrier property is enhanced by laminating such gas barrier films.

On the other hand, in the case where, as a member for a sheet of a solar cell, a film to be obtained by laminating the organic-inorganic laminate type gas barrier films (hereinafter, sometimes referred to as "composite film") is used, the composite film is demanded to maintain the barrier property at a high level even after the composite film is placed outside over long period of time in conditions of heat and humidity, or even after the composite film was bent.

### SUMMARY OF THE INVENTION

However, since such an organic-inorganic laminate type gas barrier film generally has a dense layer structure, defect is readily caused when such films are stuck. Further, such defect expands after the composite film was placed over long period of time in conditions of heat and humidity, or after the composite film was bent. The defect may reduce the gas barrier property of the gas barrier film. In addition, there is another defect in the organic-inorganic laminate type gas barrier film after being stuck, which reduces the barrier property as is the same above. That is, in the case of laminating the organic-inorganic laminate type gas barrier films, it is difficult to maintain the barrier property after the composite film was placed in conditions of heat and humidity, or after the composite film was bent.

The object of the invention is to solve the above problem, and to provide a composite film which is obtained by laminating organic-inorganic laminate type gas barrier films and which is excellent in weatherability and flexibility over long period of time.

Under such a situation, the inventor has earnestly investigated and has found that, in the case of laminating the organic-inorganic laminate type gas barrier films, the weatherability and flexibility for the obtained composite film are enhanced by using an adhesive comprising a metal alkoxide. Thereby, the invention has been achieved.

Specifically, the aforementioned problem can be solved by the following means.
[1] A composite film comprising a first gas barrier film, a second gas barrier film and an adhesive layer between the first gas barrier film and the second gas barrier film, wherein the first gas barrier film comprises a substrate film, at least one organic layer and at least one inorganic layer; the second gas barrier film comprises a substrate film, at least one organic layer and at least one inorganic layer; and the adhesive layer comprises a dry lamination adhesive and a metal alkoxide.
[2] The composite film according to [1], wherein the adhesive layer is in contact with the inorganic layer of the first gas barrier film and the inorganic layer of the second gas barrier film.
[3] The composite film according to [1], wherein the inorganic layer of the first gas barrier film is adjacent to the adhesive layer; and the inorganic layer of the second gas barrier film is adjacent to the adhesive layer.
[4] The composite film according to any one of [1] to [3], wherein the adhesive layer comprises the metal alkoxide in an amount of 5 to 30% by weight of the adhesive layer.
[5] The composite film according to any one of [1] to [4], wherein the metal alkoxide is a silane coupling agent.
[6] The composite film according to any one of [1] to [5], wherein at least one of the inorganic layers comprises an aluminum-containing compound and/or a silicon-containing compound.
[7] The composite film according to any one of [1] to [6], wherein the dry lamination adhesive is a polyurethane series adhesive.
[8] The composite film according to any one of [1] to [7], wherein at least one of the organic layers comprises an ultraviolet curable resin.
[9] The composite film according to any one of [1] to [8], wherein at least one of the organic layers is obtained by curing a polymerizable composition comprising a (meth)acrylate.
[10] The composite film according to any one of [1] to [9], wherein at least one of the substrate films is a polyester series resin film.
[11] The composite film according to any one of [1] to [10], wherein at least one of the first gas barrier film and the second gas barrier film consists of the substrate film, the inorganic layer(s), and the organic layer(s).
[12] The composition film according to any one of [1] to [11], wherein the metal alkoxide has a molecular weight of 130 to 500.
[13] The composition film according to any one of [1] to [12], wherein the adhesive layer has a thickness of 10 to 500 µm.
[14] The composition film according to any one of [1] to [13], wherein at least one of the organic layers has a thickness of 50 nm to 2000; and at least one of the inorganic layers has a thickness of 5 to 500 nm.
[15] The composition film according to any one of [1] to [14], wherein the dry lamination adhesive is a two-liquid mixing polyurethane series adhesive.
[16] The composition film according to any one of [1] to [15], wherein the metal alkoxide is a silane coupling agent; and at least one of the inorganic layers comprises a silicon oxide.
[17] The composition film according to any one of [1] to [15], wherein the metal alkoxide is a silane coupling agent; and at least one of the inorganic layers comprises a silicon oxide represented by SiOx, wherein x is 0.9 to 1.5.
[18] A member for a solar cell, comprising the composite film of any one of [1] to [17].
[19] A method for enhancing flexibility of a gas barrier film, which comprises laminating a first gas barrier film comprising a substrate, at least one organic layer and at least one inorganic layer and a second gas barrier film comprising a substrate, at least one organic layer and at least one inorganic layer through an adhesive layer comprising a dry lamination adhesive and a metal alkoxide, and then curing the adhesive layer.
[20] A method for manufacturing of a composite film, which comprises laminating a first gas barrier film comprising a substrate, at least one organic layer and at least one inorganic layer and a second gas barrier film comprising a substrate, at least one organic layer and at least one inorganic layer through an adhesive layer comprising a dry lamination adhesive and a metal alkoxide, and then curing the adhesive layer.

The invention makes it possible to provide a composite film excellent in flexibility, particularly excellent in flexibility over time. The composite film of the invention can be preferably used for a device which is used over a long period of time.

### BRIEF DESCRIPTION OF THE DRAWING

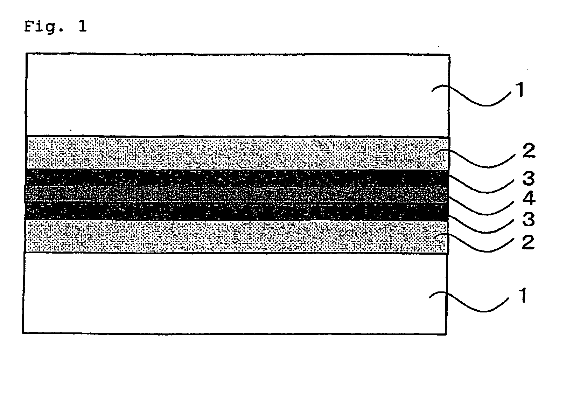

Fig. 1 shows a preferable example of embodiment of the composite film of the invention, wherein 1 is a substrate film, 2 is an organic layer, 3 is an inorganic layer, and 4 is an adhesive layer.

### DESCRIPTION OF SPECIFIC EMBODIMENTS

The contents of the invention are described in detail hereinunder. In this description, the numerical range expressed by the wording "a number to another number" means the range that falls between the former number indicating the lowermost limit of the range and the latter number indicating the uppermost limit thereof. In addition, "(meth)acrylate" means acrylate and methacrylate in the present specification.

### <Composite film>

The composite film of the invention comprises a first gas barrier film, a second gas barrier film and an adhesive layer between the first gas barrier film and the second gas barrier film, wherein the first gas barrier film comprises a substrate film, at least one organic layer and at least one inorganic layer; the second gas barrier film comprises a substrate film, at least one organic layer and at least one inorganic layer; and the adhesive layer comprises a dry lamination adhesive and a metal alkoxide.

By unifying the organic-inorganic laminate type gas barrier films through the adhesive layer containing a dry lamination adhesive and a metal alkoxide, the flexibility of the composite film is enhanced in addition that the barrier property of the composite film is enhanced.

Fig. 1 shows an example of embodiment of the composite film of the invention, wherein 1 stands for a substrate film, 2 stands for an organic layer, 3 stands for an inorganic layer, and 4 stands for an adhesive layer. Although numbers of the organic layer 2 and the inorganic layer 3 each are one in the embodiment, the numbers thereof may be each two or more. The number thereof is typically 2 to 30, preferably 3 to 20. The gas barrier film may comprise a constructing layer other than the organic layer and the inorganic layer.

In the embodiment, the inorganic layers in each of the gas barrier films of the composite film are adjacent to the adhesive layer, however, the organic layers therein may contact with the adhesive layer. In the invention, the inorganic layers in both of the gas barrier films are preferably adjacent to the adhesive layer.

### <Gas Barrier Film>

As mentioned above, the gas barrier film used in the invention necessarily comprises a substrate film and an organic layer and an inorganic layer which are provided on the substrate film. Such an organic layer and such an inorganic layer may be provided on the both side of the substrate film without diverting the scope of the invention. The gas barrier film of the invention is a film support having a barrier layer which has a function shutting oxygen, moisture, nitrogen oxides, sulfur oxides, ozone, or the like in the atmosphere.

### (Organic Layer)

The organic layer in the invention is preferably an organic layer comprising an organic polymer as a main ingredient. Herein, the main ingredient means that the highest in ingredient composing the organic layer is an organic polymer, and generally 80% by weight or more in ingredient composing the organic layer is an organic polymer.

The organic polymer is exemplified by an ultraviolet curable resin such as polyester, acrylic resin, methacrylic resin, methacrylic acid/maleic acid copolymer, polystyrene, transparent fluororesin, polyimide, fluoropolyimide, polyamide, polyamidimide, polyetherimide, cellulose acylate, polyurethane, polyether-ether ketone, polycarbonate, alicyclic polyolefin, polyarylate, polyether sulfone, polysulfone, fluorene ring-modified polycarbonate, alicyclic-modified polycarbonate, fluorene ring-modified polyester, acryloyl compound, etc..

In the invention, the organic layer is preferably a layer obtainable by curing a polymerizable composition comprising polymerizable monomers.

### (Polymerizable Compound)

The polymerizable compound for use in the invention is preferably a radical polymerizable compound and/or a cationic polymerizable compound having an ether group as a functional group, more preferably a compound having an ethylenic unsaturated bond at the terminal or in the side chain thereof, and/or a compound having epoxy or oxetane at a terminal or in a side chain thereof. Of those, preferred is a compound having an ethylenic unsaturated bond at a terminal or in a side chain thereof. Examples of the compound having an ethylenic unsaturated bond at a terminal or in a side chain thereof include (meth)acrylate compounds, acrylamide compounds, styrene compound, maleic anhydride, etc, and preferably (meth)acrylate compounds and/or styrene compound, more preferably (meth)acrylate compounds.

As (meth)acrylate compounds, preferred are (meth)acrylates, urethane-(meth)acrylates, polyester-(meth)acrylates, epoxy(meth)acrylates, etc.

As styrene compounds, preferred are styrene, α-methylstyrene, 4-methylstyrene, divinylbenzene, 4-hydroxystyrene, 4-carboxystyrene, etc.

Specific examples of (meth)acrylate compounds are mentioned below, to which, however, the invention should not be limited.

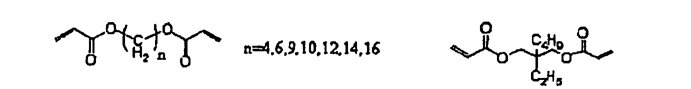

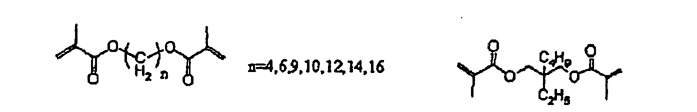

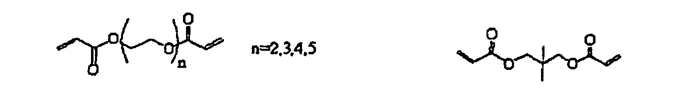

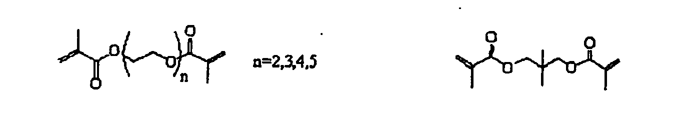

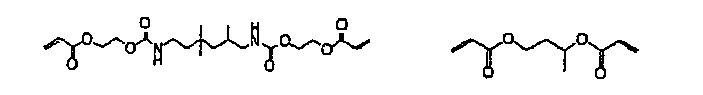

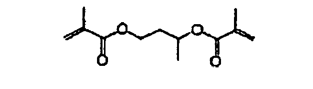

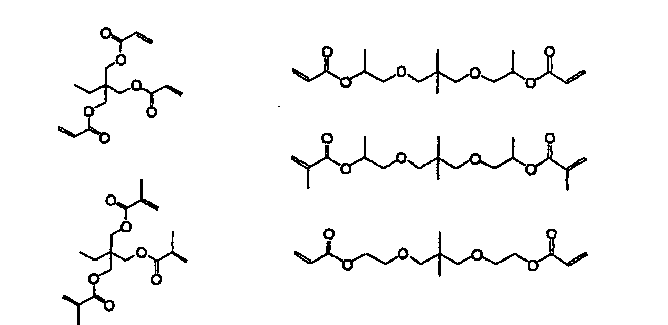

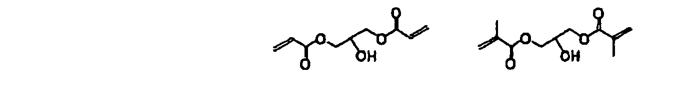

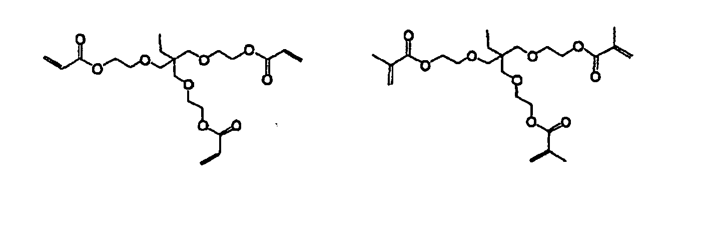

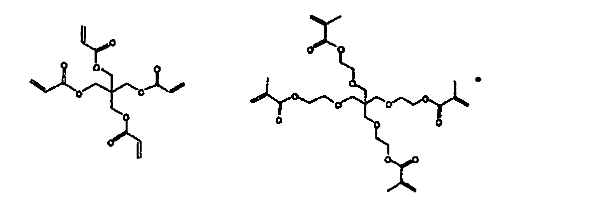

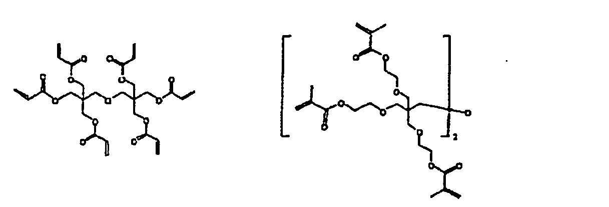

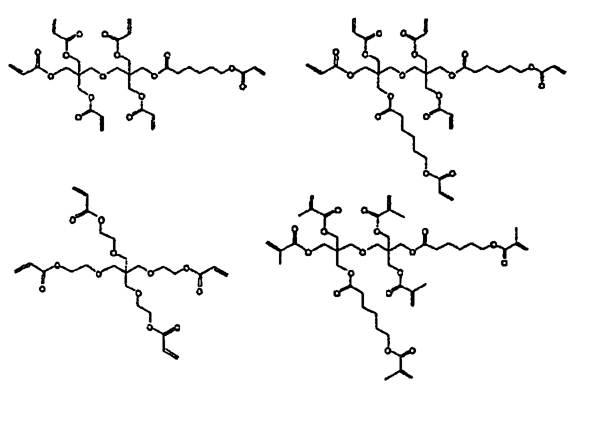

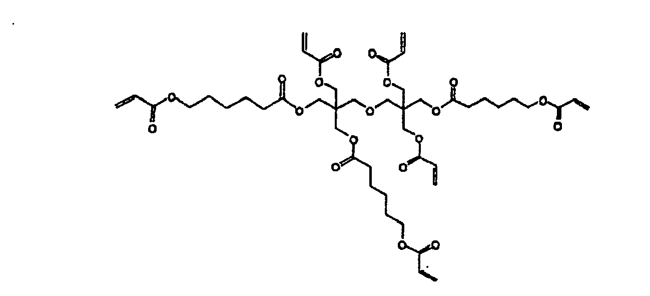

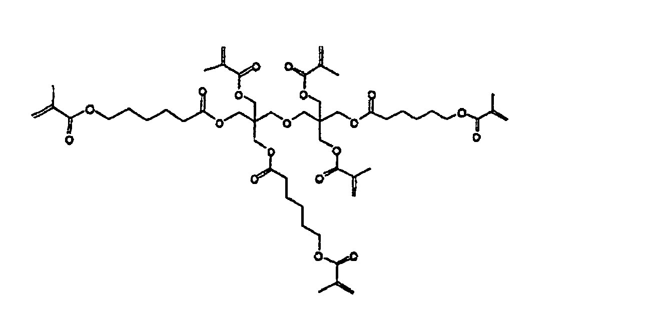

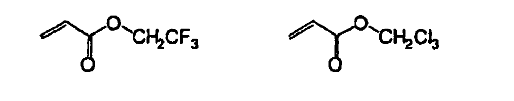

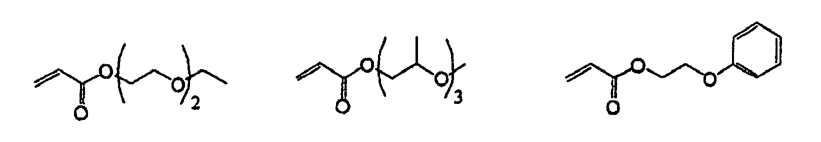

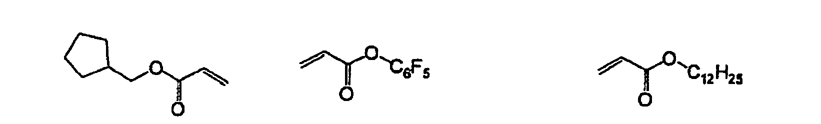

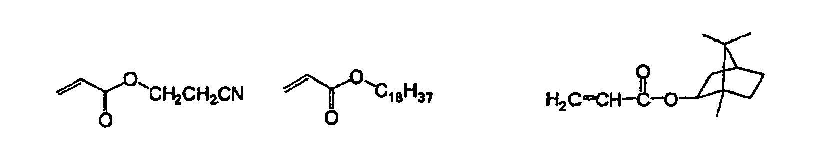

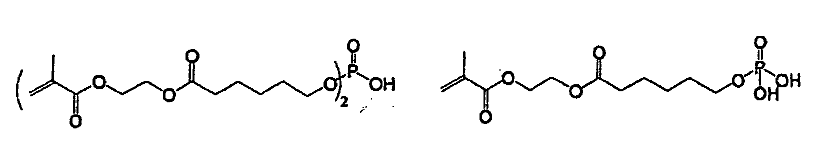

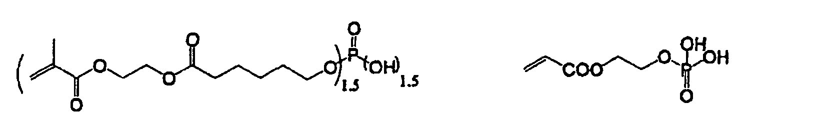

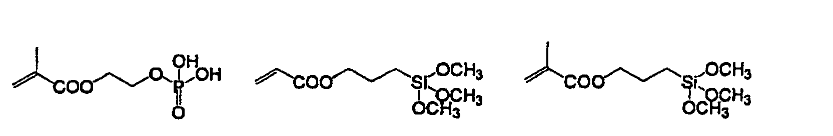

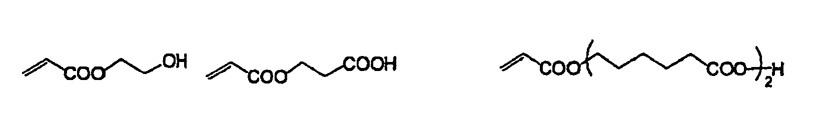

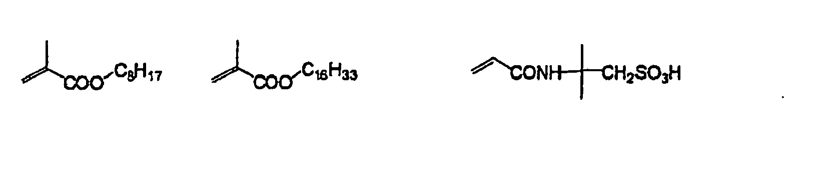

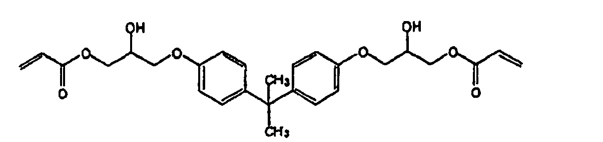

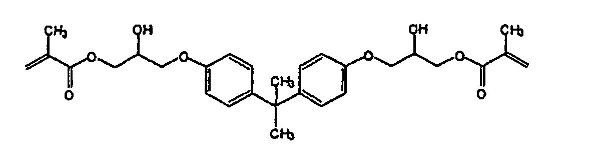

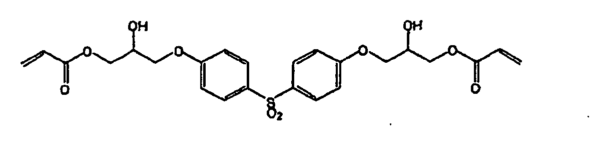

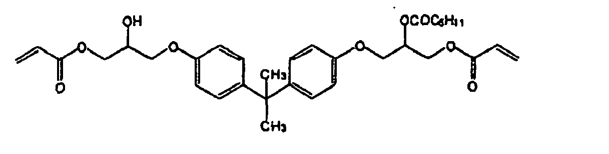

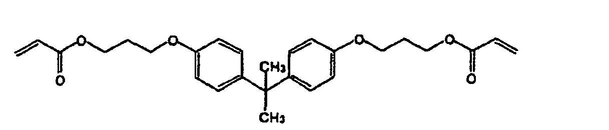

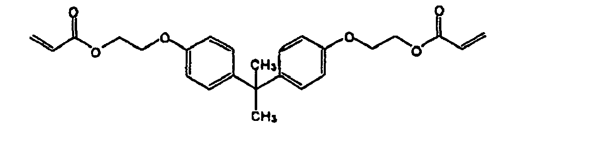

### (Polymerization Initiator)

In the case where the organic layer in the invention is formed by coating and curing a polymerizable composition comprising polymerizable compounds, the polymerizable composition may include a polymerization initiator. When a photopolymerization initiator is used, its amount is preferably at least 0.1 mol% of the total amount of the polymerizable compound, more preferably from 0.5 to 2 mol%. By setting the thus-designed composition, polymerization reaction though an active ingredient forming reaction may be suitably controlled. Examples of the photopolymerization initiator include Ciba Speciality Chemicals' commercial products, Irgacure series (e.g., Irgacure 651, Irgacure 754, Irgacure 184, Irgacure 2959, Irgacure 907, Irgacure 369, Irgacure 379, Irgacure 819), Darocure series (e.g., Darocure TPO, Darocure 1173), Quantacure PDO; Lamberti's commercial products, Ezacure series (e.g., Ezacure TZM, Ezacure TZT, Ezacure KTO46) and oligomer-type Esacure KIP series, etc.

### (Method of formation of organic layer)

The method for forming the organic layer is not specifically defined. For example, the layer may be formed according to a solution coating method and a vacuum film formation method. The solution coating method is, for example, a dipping method, an air knife coating method, a curtain coating method, a roller coating method, a wire bar coating method, a gravure coating method, a slide coating method, or an extrusion coating method using a hopper as in USP 2681294. The vacuum film formation method is not specifically defined, but is preferably a film formation method by vapor deposition or plasma CVD. In the invention, the polymer may be applied for coating as its solution, or a hybrid coating method along with an inorganic material, as in JP-A 2000-323273 and 2004-25732, may also be used.

In the invention, the polymerizable composition comprising a polymerizable compound is generally exposed to light for curing, and the light for exposure is generally a UV ray from a high-pressure mercury lamp or low-pressure mercury lamp. The radiation energy is preferably at least 0.1 J/cm², more preferably at least 0.5 J/cm². When acrylate or methacrylate is used as the polymerizable compound, such an acrylate or methacrylate may suffer from interference in polymerization owing to oxygen in air, and therefore, in its polymerization, the oxygen concentration or the oxygen partial pressure is preferably lowered. When the oxygen concentration in polymerization is lowered according to a nitrogen purging method, the oxygen concentration is preferably at most 2%, more preferably at most 0.5%. When the oxygen partial pressure in polymerization is lowered by a pressure reduction method, the whole pressure is preferably at most 1000 Pa, more preferably at most 100 Pa. Especially preferred is UV polymerization with at least 0.5 J/cm² energy radiation under a condition of reduced pressure of at most 100 Pa.

The organic layer is preferably smooth and has a hard surface. The rate of polymerization of monomer is at least 85%, more preferably at least 88%, even more preferably at least 90%, still more preferably at least 92%. The rate of polymerization as referred to herein means the ratio of the reacted polymerizable group to all the polymerizable group (acryloyl group and methacryloyl group) in the monomer mixture. The rate of polymerization may be quantitatively determined according to IR absorptiometry.

The thickness of the organic layer is not specifically defined. However, when the layer is too thin, then its thickness could hardly keep uniformity; but when too thick, the layer may be cracked by external force applied thereto and its barrier-property may lower. From these viewpoints, the thickness of the organic layer is preferably from 50 nm to 2000 nm, more preferably from 200 nm to 1500 nm.

As so mentioned in the above, the organic layer is preferably smooth. The mean roughness (Ra) at 1 µm square is preferably not more than 1 nm, more preferably not more than 0.5 nm. The surface of the organic layer is required not to have impurities and projections such as particles. Accordingly, it is desirable that the organic layer is formed in a clean room. The degree of cleanness is preferably at most class 10000, more preferably at most class 1000.

Preferably, the hardness of the organic layer is higher. It is known that, when the hardness of the organic layer is high, then the inorganic layer may be formed smoothly and, as a result, the barrier level of the gas barrier film is thereby improved. The hardness of the organic layer may be expressed as a microhardness based on a nano-indentation method. The microhardness of the organic layer is preferably at least 100 N/mm, more preferably at least 150 N/mm.

### (Inorganic Layer)

The inorganic layer is, in general, a layer of a thin film formed of a metal compound. For forming the inorganic layer, employable is any method capable of producing the intended thin film. For it, for example, suitable are physical vapor deposition (PVD) such as vapor evaporation process, sputtering process, ion plating process; various chemical vapor deposition (CVD); liquid phase growth process such as plating or sol-gel process. Not specifically defined, the component to be in the inorganic layer may be any one satisfies the above-mentioned requirements. Examples of the components include metal oxides, metal nitrides, metal carbides, metal oxinitrides and metal oxicabides. Preferred are oxides, nitrides, carbides, oxinitrides or oxicarbides comprising at least one metal selected from Si, Al, In, Sn, Zn, Ti, Cu, Ce and Ta. Of those, preferred are oxides, nitrides or oxinitrides of a metal selected from Si, Al, In, Sn, Zn and Ti; more preferred are metal oxides, nitrides or oxinitrides with Si or Al. These may comprise any other element as a subsidiary component.

As a preferred embodiment of the invention, such that using a silicon oxide as a material of the inorganic layer and adding a silane coupling agent into the adhesive layer is exemplified. By employing such embodiment, the barrier property tends to be enhanced. Of the silicon oxide, further more preferably is silicon oxide represented by SiOx, wherein x is 0.9 to 1.5. Using of such an inorganic layer in an organic EL device tended to be avoided since the film to be formed colored. However, such coloration does not become a problem in the case of using for a solar cell. Preferably, the surface smoothness of the inorganic layer formed in the invention is less than 1 nm in terms of the mean surface roughness (Ra value) in 1 µm square, more preferably at most 0.5 nm. It is desirable that the inorganic layer is formed in a clean room. Preferably, the degree of cleanness is at most class 10000, more preferably at most class 1000.

Not specifically defined, the thickness of the inorganic layer is generally within a range of from 5 to 500 nm/layer, preferably within a range of from 10 to 200 nm/layer.

### (Lamination of Organic Layer and Inorganic Layer)

The organic layer and the inorganic layer may be laminated by repeated film formation to form the organic layer and the inorganic layer in a desired layer constitution. When the inorganic layer is formed according to a vacuum film formation process such as sputtering process, vacuum evaporation process, ion plating process or plasma CVD, then it is desirable that the organic layer is also formed according to a vacuum film formation process such as the above-mentioned flash vapor deposition process. While the inorganic layer and the organic layer are formed, it is especially desirable that the organic layer and the inorganic layer are laminated all the time in a vacuum of at most 1000 Pa, not restoring the pressure to an atmospheric pressure during the film formation. More preferably, the pressure is at most 100 Pa, even more preferably at most 50 Pa, still more preferably at most 20 Pa.

### (Functional Layer)

The barrier laminate of the invention may have a functional layer on the barrier laminate or in any other position without deriving the scope of the invention. The functional layer is described in detail in JP-A 2006-289627, paragraphs 0036 to 0038. Examples of other functional layers than those are a matting agent layer, a protective layer, a solvent-resistant layer, an antistatic layer, a smoothening layer, an adhesiveness improving layer, a light shielding layer, an antireflection layer, a hard coat layer, a stress relaxing layer, an antifogging layer, an anti-soiling layer, a printable layer, an adhesive layer, etc.

### (Substrate Film)

In the gas barrier film of the invention, the substrate film is generally a plastic film. Not specifically defined in point of the material and the thickness thereof, the plastic film usable herein may be any one capable of supporting a laminate of an organic layer and an inorganic layer; and it may be suitably selected depending on the use and the object thereof. Concretely, the plastic film includes thermoplastic resins such as polyester resin, methacryl resin, methacrylic acid-maleic anhydride copolymer, polystyrene resin, transparent fluororesin, polyimide, fluoropolyimide resin, polyamide resin, polyamidimide resin, polyetherimide resin, cellulose acylate resin, polyurethane resin, polyether ether ketone resin, polycarbonate resin, alicyclic polyolefin resin, polyarylate resin, polyether sulfone resin, polysulfone resin, cycloolefin copolymer, fluorene ring-modified polycarbonate resin, alicyclic-modified polycarbonate resin, fluorene ring-modified polyester resin, acryloyl compound.

When the composite film of the invention is used as a substrate of a device such as an organic EL device to be mentioned hereinunder, it is desirable that the plastic film is formed of a heat-resistant material. Concretely, the plastic film is preferably formed of a heat-resistant transparent material having a glass transition temperature (Tg) of not lower than 100°C and/or a linear thermal expansion coefficient of at least 40 ppm/°C. Tg and the linear expansion coefficient may be controlled by the additives to the material. The thermoplastic resin of the type includes, for example, polyethylene naphthalate (PEN: 120°C), polycarbonate (PC: 140°C), alicyclic polyolefin (e.g., Nippon Zeon's Zeonoa 1600: 160°C), polyarylate (PAr: 210°C), polyether sulfone (PES: 220°C), polysulfone (PSF: 190°C), cycloolefin copolymer (COC, compound described in JP-A 2001-150584: 162°C), polyimide (Mitsubishi gas chemical company's Neopulim : 260°C), fluorene ring-modified polycarbonate (BCF-PC, compound described in JP-A 2000-227603: 225°C), alicyclic-modified polycarbonate (IP-PC, compound described in JP-A 2000-227603: 205°C), acryloyl compound (compound described in JP-A 2002-80616: 300°C or more) (the parenthesized data are Tg). In particular, for high transparency, use of alicyclic polyolefin is preferred.

When the composite film of the invention is used for purpose requesting transparency, the plastic film is transparent, or that is, its light transmittance is generally at least 80%, preferably at least 85%, more preferably at least 90%. The light transmittance may be measured according to the method described in JIS-K7105.

Not specifically defined, the thickness of the plastic film for use in the gas barrier film of the invention may be suitably selected depending on its use. Typically, the thickness may be from 1 to 800 µm, preferably from 10 to 200 µm. The plastic film may have a functional layer such as a transparent conductive layer, a primer layer, etc. The functional layer is described in detail in JP-A 2006-289627, paragraphs 0036 to 0038 as well as layers as the above described.

### (Adhesive Layer)

The adhesive layer in the invention comprises a dry lamination adhesive and a metal alkoxide. By adding such a metal alkoxide into the adhesive layer, the composite film excellent in flexibility over a long period of time is obtained. The composite film can maintain its favorable barrier property even when it has been placed in conditions of heat and humidity over a long period of time.

The dry lamination adhesive is preferably a polyurethane series adhesive, more preferably a two-liquid mixing polyurethane series adhesive.

The metal alkoxide preferably comprises silicon atom, aluminum atom, titanium atom, zirconium atom, or magnesium atom as a metal component, and more preferably comprises silicon atom as a metal component.

The molecular weight of the metal alkoxide is preferably 130 to 500, more preferably 200 to 300. The metal alkoxide in the adhesive layer preferably occupies 5 to 30% by weight of a total amount of the adhesive layer.

The metal alkoxide and the dry lamination adhesive occupies 90% by weight or more of a total amount of the adhesive layer, more preferably 99% by weight or more of a total amount of the adhesive layer.

Thickness for the composite film of the invention is not specifically limited, for example, the thickness is 10 to 500 µm, preferably 25 to 400 µm.

Water vapor permeability at 40°C and 90% relative humidity of the composite film of the invention is, for example, 0.05 g/m²/day or less, further 3e⁻³ to 1e⁻⁴ g/m²/day.

The composite film of the invention can be used for sealing devices which deteriorate by water moisture, oxygen, and the like, even if used under at ordinary temperatures and pressures over long years. The devices are exemplified by a solar cell, an electronic paper, and the like.

### (Solar Cell)

The composite film of the invention can be used as a front sheet for a solar cell or a back sheet for a solar cell. The solar cell generally has an active part which practically operates as a solar cell between a pair of substrates. In the invention, the composite film of the invention may be used as one or both of the pair of substrates.

The solar cell for which the composite film of the invention is favorably used is not specifically defined. For example, they include single crystal silicon-based solar cell devices, polycrystalline silicon-based solar cell devices, single-junction or tandem-structure amorphous silicon-based solar cell devices, gallium-arsenic (GaAs), indium-phosphorus (InP) or the like III-V Group compound semiconductor-based solar cell devices, cadmium-tellurium (CdTe) or the like II-VI Group compound semiconductor-based solar cell devices, copper/indium/selenium (CIS-based), copper/indium/gallium/selenium (CIGS-based), copper/indium/gallium/selenium/sulfur (CIGSS-based) or the like I-III-VI Group compound semiconductor-based solar cell devices, dye-sensitized solar cell devices, organic solar cell devices, etc. Above all, in the invention, the solar cell devices are preferably copper/indium/selenium (CIS-based), copper/indium/gallium/selenium (CIGS-based), copper/indium/gallium/selenium/sulfur (CIGSS-based) or the like I-III-VI Group compound semiconductor-based solar cell devices.

### (Electronic paper)

The composite film of the invention can be used in an electronic paper. The electronic paper is a reflection-type electronic display capable of attaining a high precision and a high contrast.

The electronic paper has a display media and a TFT driving the display media on a substrate. Any known display media can be used in the electronic paper. For example, any display media of electophoretic-type, electopowder flight-type, charged tonner-type, electrochromic type can be preferably used. Among them, electophoretic display media is more preferable and microcapsule-type electophoretic display media is particularly preferable. The electophoretic display media has a plural number of capsules and each capsule has at least one particle capable of moving in a suspension flow. The at least one particle is preferably an electrophoretic particle or a spinning ball. The electrophretic display media has a first plane and a second plane that are placed in parallel, and an image is displayed through one of the two planes.

A TFT formed on a substrate comprises a gate electrode, gate insulating layer, an active layer, a source electrode and a drain electrode. A TFT also comprises a resistance layer between the active layer and the source electrode and/or between the active layer and the drain electrode to attain electric connection.

When a color display with a high precision is produced, TFT's are preferably formed on a color filter to precisely align them. Normal TFT with a low electric efficiency can not be down-sized much while obtaining the necessary driving current, and when a high precision display is pursued, the rate of the area for the TFT in a pixel must be high. When the rate of the area for the TFT is high, the rate of the opening area and contrast are low. Even when a transparent amorphous IGZO-type TFT is used, light transmittance is not 100% and reduction of contrast is unavoidable. Use of the TFT disclosed in JP-A 2009-21554 and the like can reduce the rate of the TFT in a pixel and improve the rate of the opening area and contrast. High precision can also be attained by forming this type of TFT on a color filter directly.

### (Others)

Other applications of the invention are thin-film transistors as in JP-T H10-512104, touch panels as in JP-A 5-127822, 2002-48913, circularly polarizing plates as in JP-A-2002-865554, organic EL devices as in JP-A-2007-30387.

### EXAMPLES

The characteristics of the invention are described more concretely with reference to the following Examples. In the following Examples, the material used, its amount and the ratio, the details of the treatment and the treatment process may be suitably modified or changed not overstepping the sprit and the scope of the invention. Accordingly, the invention should not be limitatively interpreted by the Examples mentioned below.

### Example 1

### (Formation of Gas Barrier Film)

PET film (COSMOSHINE A4300, having thickness of 100 µm) was cut into 10 cm square. On the surface thereof, an organic layer and an inorganic layer were formed by the following process.

### (Formation of Organic Layer)

On the PET film, a polymerizable composition consisting of trimethylolpropane triacrylate (TMPTA, manufactured by DIC), 0.6 g of an ultraviolet polymerization initiator (manufactured by Chiba Specialty. Chemicals Inc., Irgacure 184), and 190 g of propylene glycol monomethyl ether acetate was coated using a wire bar, and was cured through irradiation with UV rays from a high-pressure mercury lamp (the total dose is 1.5 J/cm²) under oxygen concentration of 0.1 % or less by nitrogen substitution, thereby producing the organic layer having a thickness of about 1 µm.

### (Formation of Inorganic Layer)

Using a sputtering device or a deposition device, an inorganic layer (silicon oxide layer) was formed on the organic layer. Silicon as target, argon as flow gas, and oxygen as reactive gas were used. The formation pressure was 0.1 Pa, and the attained film thickness was 60 nm. Thus the inorganic layer was laminated on the organic layer to form a gas barrier film.

### (Preparation of Adhesive composition)

The adhesive composition was prepared by adding silane coupling agent (manufactured by TORAY dowcorning, Z-6044) into a two-liquid mixing urethane series adhesive(manufactured by Dainichiseika Color & Chemicals Mfg.Co. ,Ltd, main agent:E-372, curing agent:C-76) as an adhesive. The adhesive composition was composed of 90% by weight of the adhesive and 10% by weight of the silane coupling agent.

### (Laminating of Gas Barrier Film)

On the inorganic layer of the gas barrier film as obtained above, the above adhesive composition was coated by a bar coating method, and then, on the surface thereof, another gas barrier film as obtained above was further stacked. The stacking was carried out so that each of the inorganic layer sides contacted with the adhesive layer. Thus, the composite film was obtained.

### (Examples 2 to 4, Comparative Examples 1 to 6)

Composite films of Examples and Comparative Examples were formed according to the same method, except that each of the construction was replaced as shown in the table below. In Example 3, the amount to be added of the silane coupling agent was changed. In Example 4, aluminum tri-iso isopropoxide was added in place of the silane coupling agent.

Water vapor permeability and flexibility for the composite films obtained in Examples and Comparative Examples above were measured and evaluated according to the following methods. In addition, water vapor permeability and flexibility of the composite films after they were placed at 85°C and 85% RH for 1000 hours were measured and evaluated.

### <Measurement of Adhesiveness>

T-type peeling test for the composite films was carried out according to JIS K6854.

### <Measurement of Water Vapor Permeability according to Ca method (WVP) >

The water vapor permeability were measured according to the method described in G. NISATO, P.C.P. BOUTEN, P.J. SLIKKERVEER, et al.; SID Conference Record of the International Display Research Conference 1435-1438. The measure was carried out at 40°C and 90 % RH. The results were shown in below table.

### <Water Vapor permeability after bending>

The composite film was subjected to bending in 180° using a mandrill having a diameter of 20 mm, which was repeated ten times. Then, the water vapor permeability of the composite film was measured and evaluated according to the above method.

### <Adhesiveness and Water Vapor Permeability over time>

Each of the composite films as formed above was placed at 85°C and 85% RH for 250 hours, and then the adhesiveness and the water vapor permeability were measured and evaluated according to the above methods.

**[Table 1]**

| | Organic Layer | Thickness of Organic Layer(µm) | Method for forming Inorganic Layer | Metal alkoxide | Adhesiveness | WVP | WVP after bending | Adhesiveness (over time) | WVP (over time) |
|---|---|---|---|---|---|---|---|---|---|
| | | | | | (N/15mm) | (g/m²/day) | (g/m²/day) | (N/15mm) | (g/m²/day) |
| Example 1 | TMPTA | 1 | Sputtering | Added | 5.8 | 4.3 e⁻⁴ | 5.1e⁻⁴ | 5.8 | 5.3 e⁻⁴ |
| Example 2 | TMPTA | 1 | Deposition | Added | 5.4 | 3.1e⁻³ | 3.3e⁻³ | 5.3 | 3.5⁻³ |
| Example 3 | TMPTA | 1 | Sputtering | Added | 5.6 | 4.8 e⁻⁴ | 5.5e⁻⁴ | 5.3 | 7.1 e⁻⁴ |
| Example 4 | TMPTA | 1 | Sputtering | Added | 5.5 | 4.9e⁻⁴ | 5.8e⁻⁴ | 5.0 | 7.8e⁻⁴ |
| Com.Example 1 | TMPTA | 1 | Sputtering | Not added | 5.3 | 4.2 e⁻⁴ | 8.1e⁻⁴ | 4.9 | 1.1e⁻³ |
| Com.Example 2 | Not provided | - | Sputtering | Added | 6.1 | 1.2e⁻² | 5.5e⁻² | 5.9 | 3.3e⁻² |
| Com.Example 3 | Not provided | - | Sputtering | Not added | 5.8 | 1.1e⁻² | 5.2e⁻² | 3.1 | 4.4e⁻² |
| Com.Example 4 | TMPTA | 1 | Deposition | Not added | 5.2 | 3.5e⁻³ | 7.2e⁻³ | 3.0 | 9.9e⁻³ |
| Com.Example 5 | Not provided | - | Deposition | Added | 5.5 | 4.2 e⁻² | 1.2e⁻¹ | 5.4 | 9.7e⁻² |
| Com.Example 6 | Not provided | - | Deposition | Not added | 5.0 | 4.4e⁻² | 9.8e⁻² | 2.9 | 9.2e⁻² |

In the above table, WVP means the water vapor permeability. As is clear from the above table, it was found that reduction for the water vapor permeability after the bending test and reduction for the water vapor permeability after the humidity and heat test were controlled by using the adhesive comprising the silane coupling agent in the case where the organic-inorganic laminate type gas barrier films are stuck to each other (Examples 1 to 3). On the other hand, it was found that the water vapor permeability after the bending test and the water vapor permeability after the humidity and heat were reduced in the case where the adhesive does not comprise any metal alkoxide (Comparative Examples 1 and 4).

Similarly, it was found that the water vapor permeability after the bending test and the water vapor permeability after the humidity and heat test reduced regardless of comprising the silane coupling agent, in the case where the gas barrier films comprising only the inorganic layer are stuck to each other (Comparative Examples 2, 3, 5 and 6). This means that, although the adhesive agent comprising the silane coupling agent enhances the adhesiveness, thereby rather enhancing the barrier property, the adhesive agent comprising the silane coupling agent does not advantageously affect the moisture and heat resistance and the flexibility.

In the case where the gas barrier films comprising only the inorganic layer are stuck to each other, the water vapor permeability after the bending test and the water vapor permeability after the humidity and heat test reduced regardless of comprising the silane coupling agent. On the other hand, in the case where the organic-inorganic laminate type gas barrier films are stuck to each other, the water vapor permeability after the bending test and the water vapor permeability after the humidity and heat test can be controlled to reduce only by using the adhesive comprising the silane coupling agent. That is, the invention is based on completely different technique from the conventional laminating of films and the achievement thereof is really great.

## Claims

1. A composite film comprising a first gas barrier film, a second gas barrier film and an adhesive layer between the first gas barrier film and the second gas barrier film, wherein the first gas barrier film comprises a substrate film, at least one organic layer and at least one inorganic layer; the second gas barrier film comprises a substrate film, at least one organic layer and at least one inorganic layer; and the adhesive layer comprises a dry lamination adhesive and a metal alkoxide.

2. The composite film according to Claim 1, wherein the adhesive layer is in contact with the inorganic layer of the first gas barrier film and the inorganic layer of the second gas barrier film.

3. The composite film according to Claim 1 or 2, wherein the inorganic layer of the first gas barrier film is adjacent to the adhesive layer; and the inorganic layer of the second gas barrier film is adjacent to the adhesive layer.

4. The composite film according to any one of Claims 1 to 3, wherein the adhesive layer comprises the metal alkoxide in an amount of 5 to 30% by weight of the adhesive layer.

5. The composite film according to any one of Claims 1 to 4, wherein the metal alkoxide is a silane coupling agent.

6. The composite film according to any one of Claims 1 to 5, wherein at least one of the inorganic layers comprises an aluminum-containing compound and/or a silicon-containing compound.

7. The composite film according to any one of Claims 1 to 6, wherein the dry lamination adhesive is a polyurethane series adhesive.

8. The composite film according to any one of Claims 1 to 7, wherein at least one of the organic layers comprises an ultraviolet curable resin.

9. The composite film according to any one of Claims 1 to 8, wherein at least one of the organic layers is obtained by curing a polymerizable composition comprising a (meth)acrylate.

10. The composite film according to any one of Claims 1 to 9, wherein at least one of the substrate films is a polyester series resin film.

11. The composite film according to any one of Claims 1 to 10, wherein the dry lamination adhesive is a two-liquid mixing polyurethane series adhesive.

12. The composite film according to any one of Claims 1 to 11, wherein the metal alkoxide is a silane coupling agent; and at least one of the inorganic layers comprises a silicon oxide.

13. A member for a solar cell, comprising the composite film of any one of Claims 1 to 12.

14. A method for manufacturing of a composite film, which comprises laminating a first gas barrier film comprising a substrate, at least one organic layer and at least one inorganic layer and a second gas barrier film comprising a substrate, at least one organic layer and at least one inorganic layer through an adhesive layer comprising a dry lamination adhesive and a metal alkoxide, and then curing the adhesive layer.

## Patentansprüche

1. Verbundfilm, umfassend einen ersten Gassperrfilm, einen zweiten Gassperrfilm und eine Adhäsivschicht zwischen dem ersten Gassperrfilm und dem zweiten Gassperrfilm, worin der erste Gassperrfilm einen Substratfilm, zumindest eine organische Schicht und zumindest eine anorganische Schicht umfasst, der zweite Gassperrfilm einen Substratfilm, zumindest eine organische Schicht und zumindest eine anorganische Schicht umfasst, und die Adhäsivschicht ein Trockenlaminationsadhäsiv und ein Metallalkoxid umfasst.

2. Verbundfilm nach Anspruch 1, worin die Adhäsivschicht mit der anorganischen Schicht des ersten Gassperrfilmes und der anorganischen Schicht des zweiten Gassperrfilmes in Kontakt ist.

3. Verbundfilm nach Anspruch 1 oder 2, worin die anorganische Schicht des ersten Gassperrfilmes zur Adhäsivschicht benachbart ist; und die anorganische Schicht des zweiten Gassperrfilmes zur Adhäsivschicht benachbart ist.

4. Verbundfilm nach einem der Ansprüche 1 bis 3, worin die Adhäsivschicht das Metallalkoxid in einer Menge von 5 bis 30 Gew.-% der Adhäsivschicht umfasst.

5. Verbundfilm nach einem der Ansprüche 1 bis 4, worin das Metallalkoxid ein Silankupplungsmittel ist.

6. Verbundfilm nach einem der Ansprüche 1 bis 5, worin zumindest eine der anorganischen Schichten eine aluminiumhaltige Verbindung und/oder eine siliziumhaltige Verbindung umfasst.

7. Verbundfilm nach einem der der Ansprüche 1 bis 6, worin das Trockenlaminationsadhäsiv ein Adhäsiv der Polyurethanserie ist.

8. Verbundfilm nach einem der Ansprüche 1 bis 7, worin zumindest eine der organischen Schichten ein ultravioletthärtbares Harz umfasst.

9. Verbundfilm nach einem der Ansprüche 1 bis 8, worin zumindest eine der organischen Schichten durch Härten einer polymerisierbaren Zusammensetzung, umfassend ein (Meth)acrylat, erhalten ist.

10. Verbundfilm nach einem der Ansprüche 1 bis 9, worin zumindest einer der Substratfilme ein Harzfilm der Polyesterserie ist.

11. Verbundfilm nach einem der Ansprüche 1 bis 10, worin das Trockenlaminationsadhäsiv ein Adhäsiv aus der Polyurethanserie mit zwei gemischten Flüssigkeiten ist.

12. Verbundfilm nach einem der Ansprüche 1 bis 11, worin das Metalloxid ein Silankupplungsmittel ist; und zumindest eine der anorganischen Schichten ein Siliziumdioxid umfasst.

13. Teil für eine Solarzelle, umfassend den Verbundfilm nach einem der Ansprüche 1 bis 12.

14. Verfahren zur Herstellung eines Verbundfilmes, umfassend das Laminieren eines ersten Gassperrfilmes, umfassend ein Substrat, zumindest eine organische Schicht und zumindest eine anorganische Schicht, und einen zweiten Gassperrfilm, umfassend ein Substrat, zumindest eine organische Schicht und zumindest eine anorganische Schicht, durch eine Adhäsivschicht, umfassend ein Trockenlaminationsadhäsiv und ein Metallalkoxid, und anschließendes Härten der Adhäsivschicht.

## Revendications

1. Film composite comprenant un premier film barrière contre des gaz, un second film barrière contre des gaz et une couche adhésive entre le premier film barrière contre des gaz et le second film barrière contre des gaz, dans lequel le premier film barrière contre des gaz comprend un film de substrat, au moins une couche organique et au moins une couche inorganique ; le second film barrière contre des gaz comprend un film de substrat, au moins une couche organique et au moins une couche inorganique ; et la couche adhésive comprend un adhésif de stratification à sec et un alcoxyde métallique.

2. Film composite selon la revendication 1, dans lequel la couche adhésive est en contact avec la couche inorganique du premier film barrière contre des gaz et la couche inorganique du second film barrière contre des gaz.

3. Film composite selon la revendication 1 ou 2, dans lequel la couche inorganique du premier film barrière contre des gaz est adjacente à la couche adhésive ; et la couche inorganique du second film barrière contre des gaz est adjacente à la couche adhésive.

4. Film composite selon l'une quelconque des revendications 1 à 3, dans lequel la couche adhésive comprend l'alcoxyde métallique en une quantité de 5 à 30 % en poids de la couche adhésive.

5. Film composite selon l'une quelconque des revendications 1 à 4, dans lequel l'alcoxyde métallique est un agent de couplage de type silane.

6. Film composite selon l'une quelconque des revendications 1 à 5, dans lequel au moins une des couches inorganiques comprend un composé contenant de l'aluminium et/ou un composé contenant du silicium.

7. Film composite selon l'une quelconque des revendications 1 à 6, dans lequel l'adhésif de stratification à sec est un adhésif de la série des polyuréthanes.

8. Film composite selon l'une quelconque des revendications 1 à 7, dans lequel au moins une des couches organiques comprend une résine durcissable aux ultraviolets.

9. Film composite selon l'une quelconque des revendications 1 à 8, dans lequel au moins une des couches organiques est obtenue en faisant durcir une composition polymérisable comprenant un (méth)acrylate.

10. Film composite selon l'une quelconque des revendications 1 à 9, dans lequel au moins un des films de substrat est un film de résine de la série des polyesters.

11. Film composite selon l'une quelconque des revendications 1 à 10, dans lequel l'adhésif de stratification à sec est un adhésif de la série des polyuréthanes à mélange de deux liquides.

12. Film composite selon l'une quelconque des revendications 1 à 11, dans lequel l'alcoxyde métallique est un agent de couplage de type silane ; et au moins une des couches inorganiques comprend un oxyde de silicium.

13. Élément pour une cellule solaire, comprenant le film composite selon l'une quelconque des revendications 1 à 12.

14. Procédé pour la fabrication d'un film composite, qui comprend la stratification d'un premier film barrière contre des gaz comprenant un substrat, au moins une couche organique et au moins une couche inorganique et d'un second film barrière contre des gaz comprenant un substrat, au moins une couche organique et au moins une couche inorganique par l'intermédiaire d'une couche adhésive comprenant un adhésif de stratification à sec et un alcoxyde métallique, et ensuite le durcissement de la couche adhésive.
